Europäisches Patentamt

European Patent Office

Office européen des brevets

(11) Veröffentlichungsnummer: **0 353 828**

**A1**

(12) **EUROPÄISCHE PATENTANMELDUNG**

(21) Anmeldenummer: **89202009.0**

(22) Anmeldetag: **26.07.89**

(51) Int. Cl.⁴: **H01L 39/24 , H01L 39/14**

(30) Priorität: **02.08.88 DE 3826219**

(43) Veröffentlichungstag der Anmeldung:
**07.02.90 Patentblatt 90/06**

(84) Benannte Vertragsstaaten:
**ES GR**

(71) Anmelder: **HOECHST AKTIENGESELLSCHAFT
Postfach 80 03 20
D-6230 Frankfurt am Main 80(DE)**

(72) Erfinder: **Theis, Jürgen, Dr.
Am Tiergarten 40
D-6000 Frankfurt am Main 1(DE)**
Erfinder: **Coutandin, Jochen, Dr.
Pestalozzistrasse 9
D-6536 Langenlonsheim(DE)**
Erfinder: **Schwarz, Martin, Dr.
Le Mele Strasse 26
D-6240 Königstein/Taunus(DE)**

(54) **Supraleitendes Kabel.**

(57) Ein supraleitendes Kabel aus mindestens einem Leiter, welcher aus einer dichtgepreßten Füllung aus einem pulverförmigen supraleitenden Material und einer rohrförmigen Ummantelung aus einem organischen Kunststoff besteht.

EP 0 353 828 A1

## Supraleitendes Kabel

Die Erfindung bezieht sich auf ein supraleitendes Kabel, welches aus mindestens einem Leiter besteht. Jeder Leiter besteht wiederum aus einer Füllung aus supraleitendem Material und einer Kunststoffummantelung.

Die konventionellen supraleitenden Materialien (z.B. Niob-Legierungen), die ausschließlich bei sehr tiefen Temperaturen eingesetzt werden können, erfordern den Einsatz des sehr teuren Kühlmittels Helium.

Neue pulverförmige (ht)-supraleitende Verbindungen wurden auf der Basis von La/Ba/Cu/O von J.G. Bednorz und K.A. Müller hergestellt. Danach stellten andere Autoren (ht)-supraleitende Eigenschaften oberhalb des Siedepunkts vom flüssigen Stickstoff am $YBa_2CU_3O_x$ fest. Durch das vergleichsweise billige Kühlmittel Stickstoff verringern sich die Betriebskosten supraleitender Geräte und Anlagen und eröffnen neue, umfassende Anwendungsmöglichkeiten.

Die neuen Supraleiter sind nicht duktil. Daher lassen sich aus ihnen auch nicht ohne weiteres supraleitende Leiter (z.B. Drähte für Spulen) herstellen. Um dieses Problem zu lösen, hat man bereits Pulver aus $YBa_2Cu_3O_x$ in Silberröhrchen eingefüllt und diese zusammengepreßt oder einen supraleitenden Körper aus Oxidkeramik in ein Metallrohr eingeführt und dieses radial zusammengepreßt (EP 281 474). Damit erhöht sich die Dichte und damit die kritische Stromdichte, bei der die Supraleitung abbricht (vgl. R. Flükiger et al., KfK-Nachr. 20 (1988) 16).

Die Aufgabe bestand darin, ein Kabel zu finden, welches flexibel, kältebeständig (bis 77 K $\hat{=}$ Kp von $N_2$) und supraleitend ist.

Die Erfindung betrifft somit ein supraleitendes Kabel aus mindestens einem Leiter, welches sich aus einer rohrförmigen Ummantelung und einer dichtgepreßten Füllung aus feinpulvrigem supraleitenden Material zusammensetzt, dadurch gekennzeichnet, daß die rohrförmige Ummantelung aus einem organischen Kunststoff besteht.

Die Erfindung betrifft weiterhin ein Verfahren zur Herstellung eines supraleitenden Kabels aus einem Leiter, bei welchem man in eine rohrförmige Ummantelung ein feines Pulver eines supraleitenden Materials einfüllt und danach den Querschnitt der Ummantelung verringert, dadurch gekennzeichnet, daß man eine Ummantelung aus einem schrumpffähigen organischen Kunststoff mit dem supraleitenden Material füllt und anschließend die Ummantelung zur Auslösung des Schrumpfes auf eine Temperatur von 100 bis 380 $^\circ$C erhitzt.

Als Ummantelung dient vorzugsweise ein Kunststoffschlauch, dessen Außendurchmesser 3 bis 8 mm, in geschrumpfter Form 1 bis 4 mm, beträgt.

Die Füllung hat im allgemeinen einen Querschnitt von 4 bis 50 mm². Bei kleineren Querschnitten ist das Füllen schwierig, bei größeren ist es schwierig, den erforderlichen Preßdruck beim Schrumpfen aufzubringen. Das Verhältnis Querschnitt der Ummantelung/Querschnitt der Füllung soll mindestens 1:5 betragen. Je größer das Verhältnis, um so stärker der Preßdruck. Aus wirtschaftlichen Gründen werden Verhältnisse über 10:1 kaum mehr benutzt. Bevorzugt sind Verhältnisse von 1:2 bis 5:1.

Das Einfüllen des supraleitenden Materials geschieht durch Einrieseln, Schütten, Injizieren und Einblasen des supraleitenden Materials und vorzugsweise anschließendes Vorverdichten wie Stampfen, Pressen und Rütteln. Die so mit supraleitendem Material gefüllte, aus schrumpffähigem organischem Kunststoff bestehende Ummantelung wird zur Verringerung ihres Querschnitts in einem Kammerofen von 100 bis 380 $^\circ$C, vorzugsweise 150 bis 300 $^\circ$C erhitzt. Das nach dem Abkühlen entstehende Kabel ist flexibel und formbar.

Als Füllung für einen supraleitenden Leiter eignet sich ein fein-pulvriges und rieselfähiges supraleitendes Material mit einer mittleren Korngröße von $d_{50}$ = 1 bis 10 $\mu$m. Die Dichte des supraleitenden Pulvers im Kabel beträgt mindestens 75 % der theoretischen Dichte, bevorzugt 76-98 %, insbesondere 77-95 %.

Als supraleitendes Material kommen vor allem oxidkeramische Materialien in Betracht, wie beispielsweise kupferhaltiges supraleitendes Material und auch alle anderen supraleitenden Materialien, die in Form eines rieselfähigen Pulvers herstellbar sind.

Als bevorzugtes supraleitendes Material eignet sich $YBa_2Cu_3O_x$, worin x eine Zahl von 6,0 bis 7,2 bedeutet. Die Sprungtemperatur des supraleitenden Materials, das sich im Leiter befindet, läßt sich mit einem SQUID-Magnetometer bestimmen.

Die Ummantelung des supraleitenden Kabels besteht aus einem geschrumpften organischen Kunststoff, insbesondere einem Halogen enthaltenden Kunststoff. Dabei sind solche Kunststoffe bevorzugt, in denen das Atomverhältnis Halogen/H 1:1 oder höher ist. Hierzu zählen Fluorpolymere wie Polytetrafluorethylen (PTFE), Polyvinylidenfluorid (PVDF) und PTFE/FEP. Verwendbar sind ferner die Fluorthermoplaste PFA, FEP, ETPE und TBF. PFA ist ein Mischpolymerisat aus Tetrafluoräthylen und Perfluoralkyl-vinyläther.

FEP ist ein Mischpolymerisat aus Tetrafluoräthylen und Perfluorpropylen.

ETPE ist ein Mischpolymerisat aus Tetrafluoräthylen und Äthylen.

TBF ist ein Mischpolymerisat aus Tetrafluoräthylen, Difluoräthylen und Perfluorpropylen.

Besonders bevorzugt ist Polytetrafluorethylen.

Eine solche Ummantelung ist chemisch inert und elektrisch hoch isolierend und unter extremen Temperaturen (von -200°C bis +200°C) stabil. Die Schrumpftemperatur beträgt für Polytetrafluorethylen etwa 330°C, für Polyvinylidenfluorid etwa 175°C, für Polyolefin über 100°C und PTFE/FEP über 320°C.

Vorteilhafterweise werden bestimmte schrumpffähige Materialien wie Polyäthylen oder PVC durch Bestrahlung, beispielsweise mit geladenen Elementarteilchen, vernetzt. Dadurch wird das Material weiter verfestigt und die erreichbare Schrumpfspannung erhöht.

Geladene Elementarteilchen sind beispielsweise energiereiche Elektronen, Protonen, Deuteronen (Deuteriumkerne), Heliumkerne oder Lithiumkerne. Sie werden in Elektronenbeschleunigern oder Ionenbeschleunigern erzeugt, in denen die Elementarteilchen durch elektrische und/oder magnetische Felder beschleunigt werden, oder sie werden aus der ionisierenden Strahlung von a-Strahlen aussendenden radioaktiven Elementen ausgefiltert.

Nach dem Schrumpfen kann der Leiter durch Zugkraft verstreckt werden, um das Füllmaterial weiter zu verdichten. Der verstreckte Leiter ist flexibel und formbar.

In das Innere des Kabels kann ein metallischer Leiter eingebracht werden, beispielsweise aus Kupfer, Nickel, Konstantan, vorzugsweise ein Heizdraht eines Hochtemperatur-Laborofens; er dient dann als Notstromträger.

Durch diesen Draht läßt sich außerdem mittels eines kurzen Strom-Impulses und der daraus resultierenden Erhitzung des Drahts und der Umgebung das Füllmaterial sintern.

In hochtemperaturstabilen Ummantelungen kann nicht nur (ht-)supraleitendes Material komprimiert werden, sondern auch nicht supraleitendes Füllmaterial, das bei hohen Temperaturen in Gegenwart von Sauerstoff (z.B. $YBa_2 Cu_3 O_{7-x}$ mit x = 0,5-1) oder auch in Abwesenheit von Sauerstoff (z.B. $Bi_2 SrCaCuO_{8-y}$) gesintert wird und dabei (ht-)supraleitend wird.

Ein zu niedriger Sauerstoff-Gehalt im Füllmaterial läßt sich durch Löcher in der Ummantelung mit hoher Temperaturbeständigkeit und nachträgliche thermische Behandlung in Gegenwart von Sauerstoff wieder einbringen. Dabei sollen supraleitende Eigenschaften erhalten werden.

Das nach diesem Verfahren hergestellte Kabel enthält einen Leiter. Durch Filamentbauweise entsteht hieraus ein Kabel mit mehreren Leitern. Dabei können mehrere Leiter mittels eines weiteren Schrumpfschlauchs zusammengefaßt werden.

Die Erfindung wird durch die Beispiele näher erläutert.

## Beispiel 1

Eine rohrförmige Ummantelung aus Polyvinylidenfluorid mit einem Innendurchmesser von 4 mm, einem Außendurchmesser von 6 mm und einer Länge von 14 cm wurde mit supraleitendem Material $YBa_2 Cu_3 O_x$, wöbei x eine Zahl von 6,0 bis 7,2 ist, gefüllt und in einen geeigneten Kammerofen gegeben. Der Kammerofen wurde innerhalb von 30 min auf 200°C aufgeheizt, bei 200°C 5 min gehalten und das Kabel anschließend wieder herausgenommen. Der Innendurchmesser des Kabels betrug nun 2,7 mm bei einer Schrumpfung von 68 % (Schrumpfungsrate = 1,48).

Messungen mit einem SQUID-Magnetometer ergaben für das so hergestellte Kabel eine Sprungtemperatur von $T_c$ = 92 K.

Die Dichte des supraleitenden Pulvers in diesem Kabel betrug w = 83 % der Theorie.

## Vergleichsbeispiel 1

Eine rohrförmige Ummantelung aus Polyetrafluorethylen mit einem Innendurchmesser von 4 mm, einem Außendurchmesser von 6 mm und einer Länge von 14 cm wurde mit supraleitendem Material $YBa_2 Cu_3 O_x$, wobei x eine Zahl von 6,0 bis 7,2 ist, gefüllt und in einen geeigneten Kammerofen gegeben. Der Kammerofen wurde innerhalb von 30 min auf 400°C aufgeheizt, bei 10 min gehalten und das Kabel anschließend wieder herausgenommen. Der Innendurchmesser des Kabels betrug nun 2,7 mm bei einer Schrumpfung von 68 % (Schrumpfungsrate 1,48).

Messungen mit einem SQUID-Magnetometer ergaben für das so hergestellte Kabel keine supraleitenden Eigenschaften für T J 77 K. Die Dichte des Pulvers betrug wie in Beispiel 1 w = 83 % der Theorie.

## Ansprüche

1. Supraleitendes Kabel aus mindestens einem Leiter, welcher sich aus einer rohrförmigen Ummantelung und einer dichtgepreßten Füllung aus feinpulvrigem supraleitenden Material zusammensetzt, dadurch gekennzeichnet, daß die rohrförmige Ummantelung aus einem organischen Kunststoff besteht.

2. Kabel gemäß Anspruch 1, dadurch gekennzeichnet, daß das supraleitende Material ein oxidkeramisches Material darstellt.

3. Kabel gemäß Anspruch 2, dadurch gekennzeichnet, daß das supraleitende Material Kupfer enthält.

4. Kabel gemäß Anspruch 3, dadurch gekennzeichnet, daß das supraleitende Material die Zusammensetzung $YBa_2Cu_3O_x$, worin x eine Zahl von 6,0 bis 7,2 bedeutet, hat.

5. Kabel gemäß Anspruch 1, dadurch gekennzeichnet, daß die Ummantelung aus einem Halogen enthaltenden organischen Kunststoff besteht.

6. Kabel gemäß Anspruch 5, dadurch gekennzeichnet, daß die Ummantelung aus einem Fluorpolymeren besteht.

7. Kabel gemäß Anspruch 6, dadurch gekennzeichnet, daß die Ummantelung aus Polytetrafluorethylen besteht.

8. Kabel gemäß Anspruch 1, dadurch gekennzeichnet, daß der Querschnitt der Füllung von 4 bis 30 mm² beträgt.

9. Kabel gemäß Anspruch 1, dadurch gekennzeichnet, daß das Verhältnis Querschnitt der Ummantelung/Querschnitt der Füllung von 1,17 bis 2,0 beträgt.

10. Verfahren zur Herstellung eines supraleitenden Kabels mit einem Leiter, bei welchem man in eine rohrförmige Ummantelung ein feines Pulver eines supraleitenden Materials einfüllt und danach den Querschnitt der Ummantelung verringert, dadurch gekennzeichnet, daß man eine Ummantelung aus einem organischen schrumpffähigen Kunststoff mit dem supraleitenden Material füllt und man anschließend die Ummantelung zur Schrumpfung auf eine Temperatur von 100 bis 380° C erhitzt.

11. Verfahren nach Anspruch 10, dadurch gekennzeichnet, daß man für die Ummantelung einen durch Bestrahlung vernetzten Kunststoff einsetzt.

12. Verfahren nach Anspruch 10, dadurch gekennzeichnet, daß man das Pulver nach dem Einfüllen verdichtet.

13. Verfahren nach Anspruch 10, dadurch gekennzeichnet, daß man das Kabel nach dem Schrumpfen des Umhüllungsmantels verstreckt.

14. Verfahren nach Anspruch 10, dadurch gekennzeichnet, daß neben dem supraleitenden Material ein drahtförmiger metallischer Leiter als Notstromträger in das Innere der Ummantelung eingefüllt wird.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | BRITISH CERAMIC PROCEEDINGS, Nr. 40, März 1988, Seiten 37-44 & EUROPEAN CERAMIC SOCIETY MEETING "SUPERCONDUCTING CERAMICS", 8.-10. September 1987, Canterbury, GB; A. BRIGGS et al.: "Fabrication and properties of YBa2Cu3O7-x in monolithic, sheet and wire forms" * Seite 39, Absätze 4-5 * --- | 1-4 | H 01 L 39/24 H 01 L 39/14 |
| A | PROCEEDINGS OF THE 38TH ELECTRONICS COMPONENTS CONFERENCE, 9.-11. Mai 1988, Seiten 176-180, IEEE, New York, NY, US; E.J.A. POPE et al.: "Metalorganic polymer route to superconducting yttrium barium-copper-oxide wire" * Seite 179, Absatz 2; Figur 6 * --- | 14 | |
| P,X | SUPERCONDUCTOR SCIENCE & TECHNOLOGY, Band 1, Nr. 3, August 1988, Seiten 137-140, London, UK; M.A. LUSK et al.: "The fabrication of a ceramic superconducting wire" * Seite 137, rechte Spalte; Seite 140, Absatz 1 * ----- | 1-4 | |

RECHERCHIERTE SACHGEBIETE (Int. Cl.5)

H 01 L 39
H 01 B 12

Der vorliegende Recherchenbericht wurde für alle Patentansprüche erstellt

| Recherchenort | Abschlußdatum der Recherche | Prüfer |
|---|---|---|
| DEN HAAG | 24-10-1989 | HAMMEL E.J. |

EPO FORM 1503 03.82 (P0403)